# EUROPEAN PATENT APPLICATION

(11) **EP 1 672 705 A1**
(43) Date of publication of application: **21.06.2006**
(21) Application number: 05445093.7
(22) Date of filing: 14.12.2005
(51) Int. Cl.: H01L 33/00

(54) **A chip supporting element and method for its manufacture**

(30) Priority: 17.12.2004 SE 0403064
(71) Applicant: Johnsson Lighting Technologies In Göteborg AB, 411 34 Göteborg (SE)
(72) Inventor: Bergstedt, Leif, 52495 Ljung (SE); Löfving, Björn, 41318 Göteborg (SE); Johnsson, Kristoffer, 416 72 Göteborg (SE)
(74) Representative: Sandström, Sven

(57) **Abstract**

A chip supporting element comprises carrier of a thermally conductive material, a dielectric layer, bond wires, a conductive layer and a recess for receiving a chip, such as a LED is disclosed. The recess of the chip supporting element is coated with a light reflecting material and shaped such that the reflected light forms a light beam with a focal point outside the recess. In particular the light reflecting material is the same as the carrier thereby forming a solid heat dissipation structure in direct contact with a chip received by the chip carrier. The carrier can for example be made of aluminum or another metal or metal composition.

## Description

### FIELD OF THE INVENTION

The present invention relates to a chip-supporting element. In particular the present invention relates to a chip-supporting element for receiving a light emitting device, such as a light emitting diode, LED.

### BACKGROUND OF THE INVENTION

A conventional chip-module comprises a chip-supporting element, i.e. a mechanical support for the chip, an electrical connection to the chip and one or more heat dissipating surfaces for the chip. One problem that is particularly acute for power chips is to provide a chip-supporting element having heat dissipating characteristics such that it can provide sufficient cooling.

Another problem for chips with optical functionality is to enable chip-close focusing for receiving and/or transmitting optical radiation in a cost-efficient and robust structure. Conventionally this is obtained by additional parts made of metal, plasics or glass. Structures involving such additional parts are not desired because of the extra processing steps and the additional parts required.

In US 2002042156 describes a structure for improving heat the dissipation for a LED mounted on a chip carrier. The heat dissipation characteristics of the structure disclosed in US 2002042156 is however not sufficient for many applications. JP 7202268 describes an arrangment comprising LEDs and a lens arrangment to focus the light of the LEDs.

### SUMMARY

It is an object of the present invention to provide a chip supporting element that has heat dissipation characteristics superior to conventional chip supporting elements.

It is another object of the present invention to provide a chip supporting element that is particularly suited to support a light emitting diode, LED or other light emitting components and to enhance and/or control the light beam as transmitted by the light source.

These objects and others are obtained by the present invention as defined by the appended claims. Advantageous embodiments are recited in the dependent claims.

Thus, in accordance with the present invention a chip supporting element is disclosed. The chip supporting element comprises carrier of a thermally conductive material, a dielectric layer, bond wires, a conductive layer and a recess for receiving a chip.

The recess is coated with a light reflecting material and shaped such that the reflected light forms a light beam with a focal point outside the recess. In particular the light reflecting material is the same as the carrier thereby forming a solid heat dissipation structure in direct contact with a chip received by the chip carrier. The carrier can for example be made of aluminum or another metal or metal composition.

### BRIEF DESCRIPTION OF THE DRAWINGS

The present invention will now be described in more detail and with reference to the accompanying drawings, in which:
- Fig. 1 is a cross sectional side view of a chip supporting element formed by a solid heat dissipation material.
- Fig. 2 is a cross sectional side view of a chip supporting element having a recess with curved side walls.

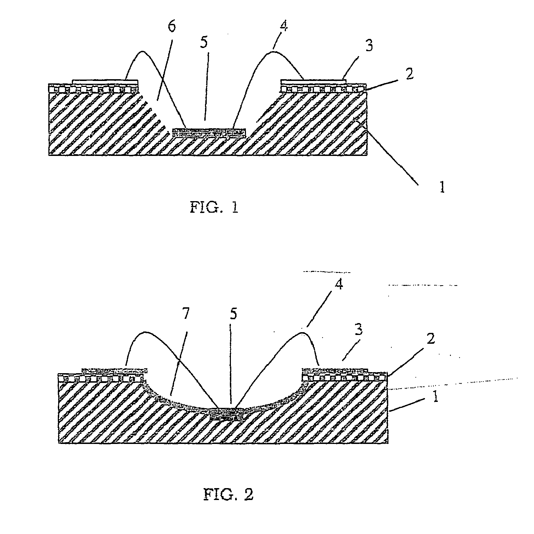

In Fig. 1 a chip supporting element is shown. The chip supporting element comprises a carrier formed by a carrier or substrate 1 having a dielectric layer 2 applied thereupon. On top of the dielectric layer a conductive layer 3 is formed. The chip supporting element further comprises bond wires 4 connected to the conductive layer 3. A recess is formed in the substrate 1. The recess is formed having a shape suitable to receive a chip 5.

Advantageous shapes of the recess are described in more detail in conjunction with Fig. 2.

The substrate 1 is made of a material having good heat dissipation characteristics. The substrate can for example be made of a metal such as aluminum or another metal or a metal composition or alloy comprising one or more of suitable metals such as Gold, Aluminum, Silver or Palladium.

In Fig. 2 a cross sectional side view of a chip supporting element having a recess with curved side walls is shown. The chip supporting element comprises a carrier formed by a substrate 1 having a dielectric layer 2 applied thereupon. On top of the dielectric layer a conductive layer 3 is formed. The chip supporting element further comprises bond wires 4 connected to the conductive layer 3. A recess is formed in the substrate 1. The recess is coated or has an outer layer 7 formed by a light reflecting material. By having the outer layer of the recess made by a light reflecting layer the chip support element can be made particularly well suited to receive a light emitting chip 5. In particular a light emitting diode, LED. The reflective material can for example be one or more of aluminum, silver, gold, nickel an palladium or any other material having sufficiently good light reflecting characteristics.

In order to provide a compact and cost-efficient design involving simple and few processing steps, the recess is according to one embodiment widest at the opening and then provided with curved, sloping walls continuously narrowing down to the bottom of the recess, where it is possible to provide a small pocket for locating a chip to be received by the chip supporting element. In yet another preferred embodiment, the light reflective layer 7 can be of the same material as the carrier 1 whereby the manufacture of the chip support element becomes very efficient since there is no need to further process the surface of the recess once it has been formed. The number of process steps is in such an embodiment limited to forming the recess(es) in the carrier made of a light reflecting and heat dissipating material, such as Aluminum, apply a layer of dielectric material, apply a conductive layer and connect bond wires to the conductive layer.

In combination, a chip arrangement comprising a chip support element and a light emitting chip 5, such as a LED will provide an efficient light source that is easy custom made for any desired application and which allows the designer to control the light beam of the light emitted form the arrangement. In particular the recess can be formed such that the focal point of the reflected light can be chosen arbitrarily outside the recess, by selecting the curved form of the walls of the recess in a corresponding manner. Currently preferred shapes of the recess includes but is not limited to half-spherical, half-parabolic rotational, frusto-conical and conical. But, as stated above the exact shape of the curved walls of the recess is a matter for the designer of each particular application to decide upon, and is ultimately governed by, among other things, the desired light emission characteristics.

In addition to having the recess coated with a light reflecting material formed into a suitable shape additional light control can be achieved by supplementing the arrangement in Fig. 2 with a lens applied on top of the recess. The lens can cover the recess partly or the whole opening. Further a spacing element can be provided in conjunction with the lens in order to even further increase the options available when controlling the light beam pattern from the light emitting chip 5.

Furthermore, in some applications it is advantageous or desired to arrange a multitude of light emitting chips in a small area. For example, the combined light effect of many light emitting chips may be desired and or required. In such an application the arrangement as described above in conjunction with Fig. 2 is very efficient. For example, the recesses can then be spaced very close indeed in one common substrate. For example a metal sheet, such as an Aluminum sheet, of suitable dimensions can be provided with a number of recesses as described above. Each of the recesses being designed to receive a light emitting chip, such as an LED. The light effects that can be achieved using such a matrix of light emitting chips where each particular light source can be optimally focused to create a combined light pattern are very powerful and can be varied within a basically unlimited range.

## Claims

1. A chip supporting element comprising:
- a carrier (1) and a recess for receiving a chip formed in the carrier, the recess being wider at the opening of the recess than at the bottom of the recess, the recess being covered with a light reflecting material **characterized in that** the walls (7) of the recess are curved in a shape being continously narrower from the opening to the bottom of the recess.

2. A chip supporting element according to claim 1, **characterized by** a dielectric layer (2) formed on the carrier (1), a conductive layer (3) formed on the dielectric layer (2), and bond wires (4) connected to the conductive layer (3).

3. A chip supporting element according to claim 1, **characterized by** a pocket at the bottom of the recess for receiving the chip.

4. A chip supporting element according to any of claims 1 - 3, **characterized by** a light emitting chip (5) located in the recess.

5. A chip supporting element according to claim 4, **characterized in that** the light emitting chip (5) is a LED.

6. A chip supporting element comprising:
- a carrier (1) and a recess for receiving a chip formed in the carrier, a dielectric layer (2) formed on the carrier (1), a conductive layer (3) formed on the dielectric layer (2), and bond wires (4) connected to the conductive layer (3), **characterized in that** the carrier (1) is formed by a material having a high heat dissipation capacity and provides a surface for formed to be in direct contact with a chip received by the chip support element.

7. A chip supporting element according to claim 7, **characterized in that** the carrier (1) is made of a solid metal.

8. A chip supporting element arrangement, **characterized by** a multitude of chip supporting elements according to any of claims 1 - 7 formed on one common carrier (1).

9. A chip supporting element arrangement according to claim 8, **characterized in that** the common carrier is a metal sheet.

10. A method of manufacturing a chip supporting element comprising a carrier (1) made of an optically reflecting material and having a good thermal dissipation characteristics, the method comprising the steps of:
- providing a dielectric layer (2) on the surface of the carrier (1),
- forming one or more recesses in the carrier, the recesses having sloping curved walls and being continously narrower from the opening down to the bottom and having a surface for receiving a chip,
- providing a conductive layer (3) on the dielectric layer (2),
- connecting bond wires (4) to the conductive layer (3).
